## Europäisches Patentamt
## European Patent Office
## Office européen des brevets

(19)

(11) Veröffentlichungsnummer: **0 213 374 B1**

(12) # EUROPÄISCHE PATENTSCHRIFT

(45) Veröffentlichungstag der Patentschrift: 31.01.90

(51) Int. Cl.⁴: **H04Q 3/72**, H04M 3/36

(21) Anmeldenummer: 86110230.9

(22) Anmeldetag: 24.07.86

(54) Schaltungsanordnung für Fernmeldeanlagen, insbesondere Fernsprechvermittlungsanlagen, mit Abfragestellen zyklisch ansteuernden Informationsabfrageeinrichtungen.

(30) Priorität: 14.08.85 DE 3529172

(43) Veröffentlichungstag der Anmeldung: 11.03.87 Patentblatt 87/11

(45) Bekanntmachung des Hinweises auf die Patenterteilung: 31.01.90 Patentblatt 90/5

(84) Benannte Vertragsstaaten:
AT BE CH DE FR GB IT LI NL SE

(56) Entgegenhaltungen:
BE-A- 654 496
DE-A- 3 443 616
DE-B- 1 537 828
GB-A- 2 006 573

IBM TECHNICAL DISCLOSURE BULLETIN, Band 20, Nr. 2, Juli 1977, Seiten 773,774, New York, US; R.W. FARR et al.: "Dynamically optimized polling system" PROCEEDINGS OF THE 10TH INTERNATIONAL TELETRAFFIC CONGRESS, Montreal, CA, 9.-15. Juni 1983, Session 5.2, Paper 4, Seiten 1-8; L.J. FORYS: "Performance analysis of a new overload strategy" PATENTS ABSTRACTS OF JAPAN, Band 7, Nr. 67 (P-184)[1212], 19. März 1983; & JP-A-57 211 630 PATENTS ABSTRACTS OF JAPAN, Band 9, Nr. 69 (E-305)[1792], 29. März 1985; & JP-A-59 207 762

(73) Patentinhaber: Siemens Aktiengesellschaft, Wittelsbacherplatz 2, D-8000 München 2(DE)

(72) Erfinder: Jans, Herbert, Dr. Ing., Ammerseestrasse 34, D-8027 Neuried(DE)

(56) Entgegenhaltungen: (Fortsetzung)
PATENTS ABSTRACTS OF JAPAN, Band 7, Nr. 251 (E-209)[1396], 8. November 1983; & JP-A-58 137 347
PATENTS ABSTRACTS OF JAPAN, Band 6, Nr. 91 (E-109)[969], 28. Mai 1982; & JP-A-57 24 145

**Beschreibung**

Die Erfindung betrifft eine Schaltungsanordnung für Fernmeldeanlagen, insbesondere Fernsprechvermittlungsanlagen, mit eine Vielzahl von Abfragestellen zyklisch ansteuernden Informationsabfrageeinrichtungen, die die Abfragestellen zum Abruf gegebenenfalls vorliegender Informationen mit hinsichtlich der verschiedenen Abfragestellen unterschiedlichen Abfragefrequenzen ansteuern und die Abfragefrequenz jeweils bezüglich einer Abfragestelle in Abhängigkeit vom Auftreten einer abzurufenden Information ändern, und mit den Informationsabfrageeinrichtungen zugeordneten Abfragespeichern, in denen für jede der Abfragestellen einzeln die individuelle Anzahl von Ansteuerungsvorgängen innerhalb eines jeweils sämtliche Abfragestellen erfassenden Gesamtansteuerzyklusses gespeichert ist, wobei in dem Abfragespeicher für jede der Abfragestellen die individuelle Anzahl von Ansteuerungsvorgängen mittels entsprechend ein- oder mehrmaliger Speicherung ihrer jeweiligen Adresse an einer dementsprechenden Zahl von Speicherstellen gespeichert ist, die innerhalb der zyklischen Folge der Gesamtheit der Speicherstellen verteilt, insbesondere regelmäßig verteilt sind und sukzessive zyklisch nacheinander gelesen werden.

Eine Schaltungsanordnung dieser Art (vergleiche deutsche Offenlegungsschrift 34 43 616 = 84 P 1950) ermöglicht es, Abfragestellen mit unterschiedlicher Häufigkeit abzufragen. Abfragestellen können einzelne Scan-Punkte, z.B. in teilnehmerindividuellen Schalteinrichtungen wie Verbindungssätzen oder Teilnehmeranschlußschaltungen, sein. Dies ist in weiteren Einzelheiten beispielsweise in der deutschen Offenlegungsschrift 2 748 795 (VPA 77 P 6230) beschrieben. Eintreffende Schaltkennzeichen werden dadurch erkannt, daß bei den an einem Scan-Punkt vorgenommenen Abfragevorgängen von einem bestimmten Zeitpunkt an andere Abfrageergebnisse gewonnen werden als davor und zwar für die Dauer des Schaltkennzeichens. Die zuletzt genannte Offenlegungsschrift beschreibt in diesem Zusammenhang, daß z.B. in Verbindungssätzen von Teilnehmerstellen abgegebene Wahlimpulse eintreffen. Die Scan-Punkte werden normalerweise in einem relativ langsamen Rhythmus abgetastet. Wird durch einen Abfragevorgang der Beginn eines Wahlimpulses erkannt, so wird der relativ langsame Abfragerhythmus durch einen relativ schnellen Abfragerhythmus ersetzt. Dadurch wird bei einer Anordnung, wie sie in der letztgenannten Offenlegungsschrift beschrieben ist, die Möglichkeit geschaffen, das Ende eines jeweiligen Wahlimpulses zeitlich möglichst exakt zu erfassen, und damit die Dauer des betreffenden Wahlimpulses. Auf diese Weise können z.B. Wahlimpulse und durch Impulse von anderer Dauer gebildete Schaltkennzeichen mit großer Sicherheit voneinander unterschieden werden.

Wird in diesem zuletzt genannten bekannten Falle ein einen Impulsbeginn anzeigendes Abfrageergebnis ermittelt, so wechselt also der Abfragerhythmus einer relativ langsamen Folge zu einer relativ schnellen Folge. Wird beim zweiten Abfragevorgang (oder beim dritten Abfragevorgang) nach einem einen Impulsbeginn anzeigenden Abfrageergebnis ein weiteres Abrageergebnis gleichen Inhalts ermittelt, so wird hieran erkannt, daß es sich tatsächlich nicht um einen Impulsbeginn sondern um eine Störung gehandelt hat. Daraufhin wird für die weiteren Abfragevorgänge der Abfragerhythmus wieder von der relativ schnellen Folge zu der langsamen Folge hin gewechselt.

In dem durch die zuletzt genannte deutsche Offenlegungsschrift bekannten Falle dient der Wechsel des Abfragerhythmusses dazu, die Abfragekapazität einer Abfrageeinrichtung durch Verlangsamung des Abfragerhythmusses zu erhöhen, indem dadurch die Zahl der Abfragestellen in entsprechendem Maße ebenfalls erhöht werden kann, wobei trotzdem eine zeitlich relativ exakte Erfassung von Schaltkennzeichen bestimmter und individueller Dauer gewährleistet wird. Handelt es sich jedoch nicht um ein zyklisches Scannen von Scan-Punkten zur Erfassung von Schaltkennzeichen durch Unterscheidung des Schaltkennzeichenzustandes vom hierzu alternativen Schaltzustand (z.B. Impulspause und "Zwischenwahlzeit"), sondern um ein Abrufen vollständiger Informationen von einzelnen Abfragestellen, so tritt ein anderes Problem in den Vordergrund. Das Aufkommen von abzurufenden Informationen kann bei verschiedenen Abfragestellen sehr unterschiedlich sein. Werden die verschiedenen Abfragestellen zyklisch gleichmäßig angesteuert, so kann es Abfragestellen geben, wo sich die abzurufenden Informationen bereits stauen, während es andere Abfragestellen gibt, bei deren Ansteuerung und Abfragung nur sporadisch Informationen zum Abruf vorliegen. In diesem Zusammenhang ist gegenüber dem Prinzip des zyklischen Scannens auch das Prinzip bekannt, Abfragestellen aufgrund von individuell abgegebenen Anforderungssignalen anzusteuern. Nachteilig ist jedoch der Aufwand, der für die Erzeugung, Abgabe, Übertragung, Aufnahme und Auswertung dieser Anforderungssignale getrieben werden muß, sowie zur sukzessiven Bearbeitung dieser Anforderungssignale. Deshalb geht die Erfindung von einer Schaltungsanordnung der eingangs angegebenen Art aus, bei der die verschiedenen Abfragestellen zyklisch angesteuert werden.

In Schaltungsanordnungen der eingangs angegebenen Art kann es nun vorkommen, daß das Aufkommen von abzurufenden Informationen an den verschiedenen Abfragestellen nicht nur ungleich ist sondern - pro Abfragestelle - außerdem Schwankungen unterliegt, und daß ein sprunghafter Wechsel des Andranges von abzurufenden Informationen an einzelnen Abfragestellen auftreten kann. Um diesem Problem zu begegnen, wurde bereits durch die deutsche Offenlegungsschrift 34 43 616 (VPA 84 P 1950) eine Schaltungsanordnung vorgeschlagen, in der vorgesehen ist, daß eine sukzessive Abfragezyklen abwickelnde Informationsabfrageeinrichtung zur Zuteilung von Abfragefrequenzen für die Abfragestellen Zykluszahlen diesen zuordnet und speichert, die jeweils die Anzahl von Abfragezyklen angeben, bei denen die betreffende Abragestelle je einmal angesteuert wird. Eine Abfragestelle wird demgemäß nur einmal in einem Abfragezyklus oder in zwei oder mehr Abfragezyklen abgefragt, und zwar nach Maßgabe der jeweils gespeicherten Zykluszahl. Ferner ist gemäß dieser Schaltungsanordnung vorgeschlagen, daß die Informationsabfrageeinrichtung bei jedesmaligem Erhalt einer Information von einer Abfragestelle diese sofort beim nächsten Abfragezyklus erneut ansteuert und entweder dies bei abermaligem Erhalt einer Information wiederholt und im gegenteiligen Falle von da an den Abfragerhythmus nach Maßgabe der für diese Abfragestelle gespeicherten Zykluszahl wieder fortsetzt. Demgemäß wird also der Abfragerhythmus pro Abfragestelle von einem der betreffenden Abfragestelle individuell zugeordneten Abfragerhythmus auf einen einheitlichen maximalen Abfragerhythmus heraufgesetzt. Darüber hinaus ist gemäß der genannten vorgeschlagenen Schaltungsanordnung vorgesehen, daß die von den verschiedenen Abfragestellen aufgenommenen Informationen in Zeitintervallen pro Abfragestelle gezählt werden und die Zykluszahlen umgekehrt proportional nach Maßgabe dieser Zählergebnisse nach jedem Zeitintervall erneut angeglichen werden, z.B. jeweils um den Wert 1. Danach werden also die pro Abfragestelle gespeicherten Zykluszahlen je nach dem tatsächlichen Verkehrsaufkommen dynamisch angepaßt.

Bei einer Schaltungsanordnung dieser Art bewirkt also ein stärkerer Andrang von abzufragenden Informationen an einer Abfragestelle, daß diese anstatt nach Maßgabe der jeweils gespeicheren Zykluszahl vielmehr bei jedem Abfragezyklus abgefragt werden. Dies bedeutet, daß diese Abfragestellen mit zurzeit stärkerem Andrang von abzufragenden Informationen gleich oft abgefragt werden. Ein stärkerer Andrang von abzufragenden Informationen an allen Abfragestellen würde zur Folge haben, daß sämtliche Abfragestellen gleich oft abgefragt werden. Dadurch würde der durch die pro Abfragestelle gespeicherten Zykluszahlen erzeugte Effekt, daß die verschiedenen Abfragestellen unterschiedlich oft abgefragt werden, gerade in Zeiten besonders starken Andranges von abzufragenden Informationen völlig nivelliert werden. (Siehe auch Dokument DE-B 1 537 828, welches ein Verfahren zur Auswahl dezentraler Einrichtungen durch eine zentrale Einrichtung zeigt.)

Für die Erfindung besteht die Aufgabe, in einer Schaltungsanordnung der eingangs angegebenen Art dafür zu sorgen, daß bei ungleichem Aufkommen von abzurufenden Informationen an den verschiedenen Abfragestellen, sowie bei diesbezüglichen Schwankungen und bei sprunghaftem Wechsel des Andranges von abzurufenden Informationen an einzelnen Abfragestellen die für diese vorgesehene unterschiedliche Abfragehäufigkeit nicht einfach nivelliert wird, wobei jedoch die Informationsabfrageeinrichtungen auf den Andrang von abzufragenden Informationen reagieren sollen, um einer Staubildung bezüglich bei den Abfragestellen abzufragender Informationen entgegenzuwirken. In diesem Zusammenhang besteht für die Erfindung des weiteren die Aufgabe, sowohl den schaltungstechnischen Aufwand als auch den steuerungstechnischen Arbeitsaufwand für die Berücksichtigung des schwankenden und teils auch sprunghaft wechselnden Andrangs von abzufragenden Informationen gegenüber der genannten vorgeschlagenen Schaltungsanordnung zu verringern. Dabei soll die Erfindung besonders der Tatsache Rechnung tragen, daß die Anzahl der pro Abfragestelle vorliegenden einzeln nacheinander abzufragenden Informationen offen ist, daß also proAbfragestelle auch je mehrere Informationen zugleich abfragebereit vorliegen können, und daß unter besonderer Berücksichtigung dessen diejenigen Mittel und Vorgänge besonders einfach gestaltet sein sollen, durch die die Abfragevorgänge dem schwankenden und teils sprunghaft wechselnden Andrang an abzufragenden Informationen angepaßt werden. Dabei soll der Aufwand an Mitteln und an abzuwickelnden Arbeitsabläufen gering gehalten werden, der für die Angleichung der Abfragevorgänge und ihrer Häufigkeit proAbfragestelle an die Schwankungen und an sprunghafte Wechsel des Andranges von abzufragenden Informationen getrieben ist.

Die Erfindung löst die gestellte Aufgabe dadurch, daß nach einem Lesen einer Adresse einer Abfragestelle aus einer zuerst erreichten Speicherstelle bei Ausbleiben einer nach Ansteuerung dieser Abfragestelle mit dieser Adresse von dieser Abfragestelle jeweils erwarteten Information in dem Speicher anhand der betreffenden Adresse diejenige nächste weitere Speicherstelle aufgesucht wird, an der die gleiche Adresse gespeichert ist, daß hier in Zuordnung zu dieser Adresse ein Merkbit gespeichert wird, daß danach die auf die zuerst erreichte Speicherstelle unmittelbar folgende Speicherstelle zur Fortsetzung des sukzessive aufeinander folgenden Lesens der gespeicherten Adressen aufgesucht wird, daß bei Vorliegen eines an einer Speicherstelle gespeicherten Merkbits eine Ansteuerung der betreffenden, mittels dieser Adresse ansteuerbaren Abfragestelle unterdrückt wird, und daß hierbei das Merkbit wieder gelöscht wird.

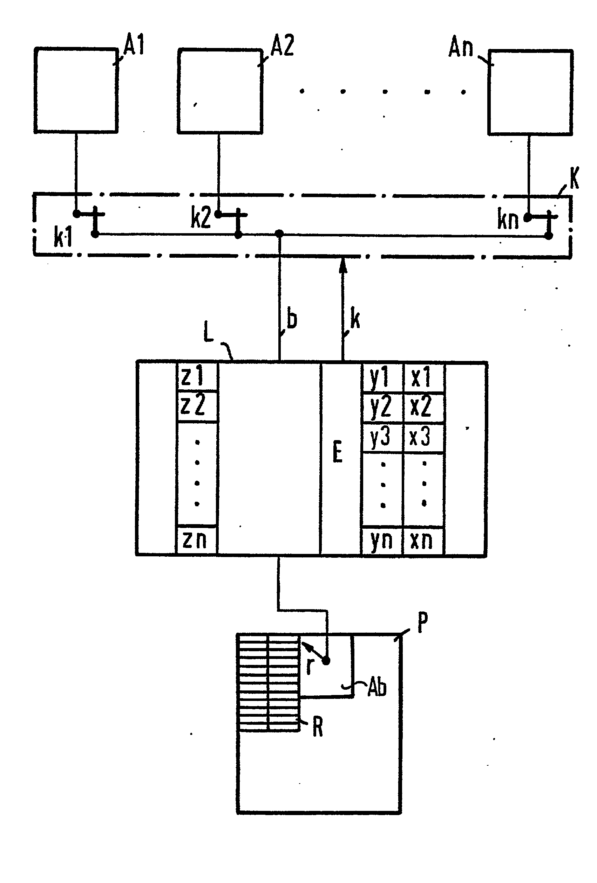

In der Zeichnung ist ein Ausführungsbeispiel der Erfindung nur in wesentlich zu ihrem Verständnis beitragenden Bestandteilen dargestellt, worauf dieselbe jedoch keineswegs beschränkt ist.

Das Ausführungsbeispiel zeigt auszugsweise eine Schaltungsanordnung der Fernsprechvermittlungstechnik, die in ihren vielfältigen Realisierungsmöglichkeiten als bekannt vorausgesetzt wird. Im vorliegenden Falle möge es sich um eine Fernsprechvermittlungsanlage handeln, bei der die gesamten Steuerungsvorgänge, z.B. Verbindungsherstellungsvorgänge, zentral und/oder teilzentral gesteuert werden. Deren Abwicklung möge ein zentrales oder teilzentrales informationsverarbeitendes Schaltwerk P dienen. Naturgemäß hat es eine hinsichtlich der Informations-Verarbeitungskapazität begrenzte Leistungsfähigkeit.

In Fernsprechvermittlungsanlagen sind verbindungsindividuelle Schalteinrichtungen in großer Anzahl vorhanden. Bei diesen verbindungsindividuellen Schalteinrichtungen kann es sich um Teilnehmeranschlußschaltungen, Wahlempfangssätze, Verbindungssätze, Leitungsabschlußschaltungen von Orts- und Fernverbindungsleitungen und dergleichen handeln. Im Falle der Ausbildung der Fernsprechvermittlungsanlage in PCM-Technik möge es sich bei den genannten verbindungsindividuellen Schalteinrichtungen um Ports in den Anschlußgruppen handeln. Detaillierte Zusammenhänge hierüber sind in der Beschreibung des Digitalvermittlungssystems EWSD im Beiheft der Zeitschrift "telcom report" von 1981 sehr detailliert beschrieben.

In den verbindungsindividuellen Schalteinrichtungen treffen Informationen ein, die zu verarbeiten sind. Hierbei handelt es sich um sämtliche Schaltkennzeichen, die von Teilnehmerstellen aus abgegeben werden, von denen aus Teilnehmer Verbindungen herzustellen beabsichtigen. Entsprechendes gilt für verbindungsindividuelle Schalteinrichtungen, die nicht teilnehmerindividuell sind, z.B. Verbindungssätze, Leitungsabschlußschaltungen und dergleichen.

Sämtliche in den verbindungsindividuellen Schalteinrichtungen eintreffenden Informationen sind an zentraler oder teilzentraler Stelle zu verarbeiten. Diese Informationen werden in an sich bekannter Weise mit Hilfe von Scan-Vorgängen laufend abgefragt, d.h. von den verbindungsindividuellen Schalteinrichtungen durch Informationsabfrageeinrichtungen abgerufen. Im folgenden ist deshalb anstelle von verbindungsindividuellen Schalteinrichtungen vorwiegend - im allgemeinerem Sinne - von Abfragestellen die Rede.

Im oberen Teil der Zeichnung sind Abfragestellen A1, A2, bis An angedeutet. Unterhalb davon ist auszugsweise eine Koppeleinrichtung K, eine Informationsabfrageeinrichtung L, zu der auch diese Koppeleinrichtung gehört, und ein zentraler Prozessor P auszugsweise wiedergegeben. In diesem Zusammenhang sei auf die deutsche Offenlegungsschrift 3 128 365 verwiesen, in der ein Anwendungsfall für die erfindungsgemäße Schaltungsanordnung erläutert ist. In diesem bekannten Fall wären die Abfragestellen Puffereinrichtungen; die Informationsabfrageeinrichtung wäre eine Eingabe-/Ausgabe-Einrichtung. Die bekannte Anordnung kann in der erfindungsgemäßen Weise ausgebildet werden. Außerdem ist in der bereits erwähnten Zeitschrift "telcom report" ein entsprechendes Digitalvermittlungssystem beschrieben.

Die in der Zeichnung auszugsweise wiedergegebene Informationsabfrageeinrichtung L steuert die Vielzahl von Abfragestellen A1 bis An regelmäßig mit Hilfe der ihr zugeordneten Koppeleinrichtung K an, die Koppelschaltmittel k1 bis kn pro Abfragestelle aufweist. Die Steuerung der Koppeleinrichtung K durch die Informationsabfrageeinrichtung L erfolgt über einen Steuerweg k in an sich bekannter Weise. Die Ansteuerung kann auch in ebenfalls bekannter Weise mit Hilfe von Adressen erfolgen, die über ein Adressenvielfach zu den Abfragestellen hin übertragen werden, in denen dann entsprechende Anschaltemittel die jeweilige Abfragestelle an einen gemeinsamen Datenbus anschaltet. In diesem Falle wären also die Koppelschaltmittel k1 bis kn in den Abfragestellen A1 bis An untergebracht. Ebenso ist es möglich, die Ansteuerung der Abfragestellen durch die Informationsabfrageeinrichtung L über einen gemeinsamen Datenbus im Zeitmultipex in an sich bekannter Weise zu bewerkstelligen.

Die Informationsabfrageeinrichtung L steuert also die Abfragestellen A1 bis An zum Abruf von gegebenenfalls in den Abfragestellen vorliegenden Informationen regelmäßig nacheinander an. Diese Ansteuerung erfolgt mit hinsichtlich der verschiedenen Abfragestellen unterschiedlichen Abfragefrequenzen. Dies wird dadurch bewerkstelligt, daß bei jedem Abfragezyklus einige der Abfragestellen je nur ein Mal, andere Abfragestellen zwei Mal, andere drei Mal u.s.w. angesteuert werden, wodurch also die Abfrage hinsichtlich der verschiedenen Abfragestellen mit unterschiedlicher Häufigkeit erfolgt. Wie im einzelnen noch detailliert erläutert werden wird, vermag die Informationsabfrageeinrichtung L außerdem die Abfragefrequenz jeweils bezüglich jeder der Abfragestellen in Abhängigkeit vom Auftreten abzurufender Informationen zu ändern. In dem Maße, wie jeweils bei einem Abfragezyklus Abfragestellen nicht angesteuert werden, verkürzt sich folglich der betreffende Abfragezyklus zeitlich in seiner Gesamtheit.

Die Informationsabfrageeinrichtung L bewerkstelligt die Ansteuerungsvorgänge über den Steuerweg k. Dies wird mit Hilfe einer Ansteuereinrichtung E der Informationsabfrageeinrichtung L durchgeführt. Diese enthält einen aus Speicherstellen y1 bis yz bestehenden Abfragespeicher. An jeder Speicherstelle ist je eine der Ansteuerung je einer der Abfragestellen A1 bis An dienende Adresse gespeichert. Von jeder dieser Schalteinrichtungen (Abfragestellen) ist die zugehörige Adresse wenigstens je ein Mal gespeichert und zwar von einigen nur ein Mal, von einigen zwei Mal, d.h. je ein Mal an zwei verschiedenen Speicherstellen, von einigen drei Mal, also entsprechend an drei verschiedenen Speicherstellen, usw. bis maximal z.B. acht Mal an acht verschiedenen Speicherstellen.

Die Ansteuereinrichtung E steuert die Abfragestellen A1 - An dadurch an, daß sie sukzessive und in zyklischer Folge nacheinander die Speicherstellen y1 bis yz sucht-hierbei handelt es sich um einen Gesamtansteuerungszyklus im einleitend angegebenen Sinne - und einzeln nacheinander die in ihnen gespeicherten Adressen der Abfragestellen liest und die dabei erhaltenen Adressen an die Koppeleinrichtung K sukzessive nacheinander überträgt. Hier bewirken sie einzeln nacheinander die Anschaltung der jeweiligen Abfragestellen an einen Prozessor P, der mit Hilfe einer Abrufeinrichtung Ab die auf diese Weise jeweils angesteuerte Abfragestelle auf Vorliegen einer abrufbaren Information abfragt. Erhält die Abrufeinrichtung Ab über einen Datenweg b und über die Informationsabfrageeinrichtung L eine Information, so speichert sie diese mit Hilfe einer Schreibeinrichtung r in einem Listenspeicher R des Prozessors P in an sich bekannter Weise, der sie zur Verarbeitung wiederum von hier nach und nach abruft.

Die verschiedenen Abfragestellen werden also mit unterschiedlichen Abfragefrequenzen abgefragt, wozu die genannte Anzahl von Speicherungen der Adressen jeder der Abfragestellen dient.

Ist eine Adresse einer Abfragestelle in dieser Weise mehrmals im Abfragespeicher gespeichert, so sind diese Speicherungen in der Reihe der Speicherstellen y1 bis yz so gleichmäßig verteilt, daß die betreffende Abfragestelle in ungefähr gleichen Zeitabständen nacheinander angesteuert wird. In dem aus den Speicherstellen y1 bis yz bestehenden Abfragespeicher ist also die individuelle Anzahl von Ansteuerungsvorgängen pro Abfragestelle durch die Anzahl von Speicherungen von deren jeweiliger Adresse gespeichert.

Die der Abfragefrequenz gleichkommende Abfragehäufigkeit für die Abfragestellen ist nicht nur durch die beschriebene Anzahl von Speicherungen pro Abfragestelle bestimmt, sondern wird durch die Informationsabfrageeinrichtung L außerdem in Abhängigkeit vom Auftreten einer abzurufenden Information fallweise geändert. Immer, wenn eine Abfragestelle bei einem Abgefragtwerden durch Ansteuerung mittels ihrer Adresse keine Information geliefert hat, also jedesmal bei Ausbleiben einer nach Ansteuerung einer Abfragestelle mit der jeweiligen Adresse von dieser Abfragestelle jeweils erwarteten Information wird der als nächster vorgesehener Ansteuerungsvorgang unterdrückt. Wiederholt sich dies für eine Abfragestelle laufend, so wird dadurch die Abfragehäufigkeit für jene also auf die Hälfte herabgesetzt.

Um dies zu bewerkstelligen, ist erfindungsgemäß vorgesehen, daß nach einem Lesen einer Adresse einer Abfragestelle, zum Beispiel A2, aus einer zuerst erreichten Speicherstelle, zum Beispiel y2, bei Ausbleiben einer nach Ansteuerung dieser Abfragestelle mit dieser Adresse von dieser Abfragestelle jeweils erwarteten Information in dem Speicher anhand der betreffenden Adresse diejenige nächste weitere Speicherstelle, zum Beispiel yp, aufgesucht wird, an der die gleiche Adresse, also zum Beispiel wiederum die Adresse der Abfragestelle A2, gespeichert ist, daß hier in Zuordnung zu dieser Adresse ein Merkbit an einem zu dieser Speicherstelle gehörenden Speicherplatz, zum Beispiel xp, gespeichert wird und daß danach die auf die zuerst erreichte Speicherstelle, zum Beispiel y2, unmittelbar folgende Speicherstelle, zum Beispiel y3, zur Fortsetzung des sukzessive aufeinander folgenden Lesens der gespeicherten Adressen aufgesucht wird.- Liegt an einem zu dieser einen Speicherstelle, zum Beispiel yp gehörenden Speicherplatz, zum Beispiel xp, bereits ein Merkbit gespeichert vor, so wird eine Ansteuerung der betreffenden Abfragestelle (zum Beispiel Ap, in der Zeichnung nicht dargestellt), die also mit der an dieser Speicherstelle (yp) gespeicherten Adresse an sich ansteuerbar wäre, unterdrückt, wobei das Merkbit dann wieder gelöscht wird.

Erreicht also die Ansteuereinrichtung E im Zuge des zyklischen Lesens von Adressen von Abfragestellen eine Speicherstelle, zum Beispiel y2, mit einem Speicherplatz, zum Beispiel x2, an dem ein Merkbit gespeichert ist, so löscht sie dasselbe an diesem Speicherplatz und verwirft zugleich aufgrund des gespeicherten Merkbits die betreffende Adresse, d.h. die Adresse der betreffenden Abfragestelle, z.B. A2, indem sie diese Adresse nach einem vorausgehenden Lesen aus der betreffenden Speicherstelle wieder löscht (ohne daß aber diese Adresse an der betreffenden Speicherstelle selbst gelöscht wird!), oder indem sie diese Adresse erst gleich gar nicht liest. Dadurch wird eine Ansteuerung der entsprechenden Abfragestelle, z.B. A2, mit der betreffenden Adresse unterdrückt und die Ansteuereinrichtung E wird zur nächsten Speicherstelle, zum Beispiel y3, weitergeschaltet.

Wird nach dem Lesen einer Adresse einer Abfragestelle, z.B. A2, diese in der beschriebenen Weise angesteuert, wird aber dann von ihr keine Information erhalten, so erfolgt die Speicherung eines Merkbits an einem entsprechenden späteren Speicherplatz; hierzu sucht die Ansteuereinrichtung E mit Hilfe der zuvor gelesenen Adresse diejenige nächste Speicherstelle, zum Beispiel yp, auf, an der sie dieselbe Adresse gespeichert vorfindet. Ferner speichert die Ansteuereinrichtung E an dem zu dieser Speicherstelle, zum Beispiel yp, gehörenden Speicherplatz, zum Beispiel xp, das zuletzt erwähnte Merkbit. Sodann sucht die Ansteuereinrichtung die auf die zuerst angesteuerte Speicherstelle, zum Beispiel y2, unmittelbar folgende Speicherstelle, zum Beispiel y3, auf. Dies kann - wie anschließend genauer beschrieben wird - auf dreierlei Weise geschehen.

Nach einer ersten Ausführungsvariante hierzu zählt die Ansteuereinrichtung E beim Suchlauf von der zuerst angesteuerten Speicherstelle y2 zu derjenigen weiteren Speicherstelle, an der die gleiche Adresse gespeichert ist, zum Beispiel yp, die Zahl der Schritte mit Hilfe einer Zähleinrichtung z1 - zn und wird nach Einspeicherung des Merkbits an dem betreffenden Speicherplatz, zum Beispiel xp, wieder um eine um eins geringere Anzahl von Schritten (Anzahl von Speicherstellen) zurückgesteuert. Dabei kann diese durch die Schritte-Zählung ermittelte Zahl nachträglich um eins vermindert werden; oder bei Erreichen der genannten weiteren Speicherstelle, z.B. yp, wo also die gleiche Adresse gespeichert ist, wird der bei Erreichen der unmittelbar davor liegenden Speicherstelle, z.B. y (p - 1), erreichte Zählwert verwendet.

Nach einer zweiten ähnlichen Ausführungsvariante zählt die Ansteuereinrichtung E in gleicher Weise mit der zu einer Zähl- und Subtrahiereinrichtung ausgestalteten Zähleinrichtung z1 - zn diese Zahl der Schritte, subtrahiert dann aber diese Zahl von der um eins erhöhten Gesamtzahl von n Speicherstellen, und wird dann nach der wie oben beschrieben durchgeführten Einspeicherung des Merkbits um die dieser Differenz entsprechende Zahl von Schritten (Anzahl von Speicherstellen) weitergeschaltet, d.h. also vorwärts zyklisch fortsetzend über die letzte Speicherstelle yz und die erste Speicherstelle y1 hinaus bis zu der betreffenden Speicherstelle, z.B. y3. In beiden Fällen gelangt die Ansteuereinrichtung schließlich so auf die auf die ursprünglich angesteuerte Speicherstelle, zum Beispiel y2, nächstfolgende Speicherstelle, zum Beispiel y3.

Nach einer dritten Ausführungsvariante wird die Ansteuereinrichtung E nach ihrem Suchlauf von der zuerst angesteuerten Speicherstelle, zum Beispiel y2, auf die weitere Speicherstelle, zum Beispiel yp, wo also die gleiche Adresse gespeichert sein möge, und nach Einspeicherung des Merkbits an dem zu ihr gehörenden Speicherplatz, zum Beispiel xp, zu einem Rückwärts-Suchlauf umgesteuert, der im Falle dieser dritten Ausführungsvariante aber mit Hilfe der gleichen und in der Ansteuereinrichtung E zwischengespeicherten, ursprünglich gelesenen Adresse abgewickelt wird, bis die Ansteuereinrichtung erneut die ursprünglich angesteuerte Speicherstelle, zum Beispiel y2, erreicht hat, wo ja diese Adresse gespeichert ist; danach wird die Ansteuereinrichtung E wieder um einen Schritt vorwärts geschaltet, das heißt zu der Speicherstelle, zum Beispiel y3, die auf die ursprünglich angesteuerte Speicherstelle, zum Beispiel y2, unmittelbar folgt.

Jedesmal, wenn also eine Adresse aus einer Speicherstelle gelesen wird, wird zugleich geprüft, ob an dem dieser Speicherstelle, zum Beispiel y2 zugeordneten Speicherplatz, zum Beispiel x2 ein Merkbit bereits gespeichert ist. Bei Vorliegen eines hier gespeicherten Merkbits wird eine Ansteuerung der betreffenden mittels dieser Adresse ansteuerbaren Abfragestelle, z.B. A2, unterdrückt und ein hierbei bereits gespeichertes Merkbit wieder gelöscht. Dagegen wird bei Ausbleiben einer nach Ansteuerung einer Abfragestelle jeweils erwarteten Information das Merkbit in Zuordnung zu der betreffenden Adresse in der zuvor beschriebenen erfindungsgemäßen Weise gespeichert.

Die zuvor beschriebenen Vorgänge werden durch die Ansteuereinrichtung E bewerkstelligt. Immer also, wenn sie aus einer der Speicherstellen, z.B. y2, erneut eine Adresse einer Abfragestelle gelesen hat, prüft sie, ob an dem zugeordneten Speicherplatz, z.B. bei x2, das Merkbit gespeichert ist. Wenn dies zutrifft, löscht die Ansteuereinrichtung dasselbe an dem betreffenden Speicherplatz, z.B. x2; ferner löscht sie die zuvor gelesene Adresse der betreffenden Abfragestelle, z.B. A2, bei sich selber, nachdem sie es also gelesen hat (löscht diese Adresse jedoch nicht an der betreffenden Speicherstelle, z.B. y2) und schaltet den zyklischen Lesevorgang um eine Speicherstelle weiter, z.B. also zur Speicherstelle y3, wodurch die mit der letzten Adresse vorbereitete Ansteuerung einer Abfragestelle, z.B. A2, ein Mal unterdrückt ist, weil bei der betreffenden früheren Ansteuerung derselben Abfragestelle, d.h. beim vorigen Ansteuerzyklus, keine Information erhalten worden war.

Die Erfindung hat auch für den Anwendungsfall Bedeutung, daß die Abfragestellen A1 bis An verbindungsindividuelle Schalteinrichtungen sind, ferner aber auch dafür, daß diese Abfragestellen Zwischenspeicher (Message Buffer) von Teilsteuerwerken von Anschlußgruppen sind (vergleiche die Beschreibungen in der oben bereits erwähnten Zeitschrift "telcom report"). In einem solchen Anwendungsfall umfassen die Abfragestellen also u.a. Speicher für je eine ganze Anzahl von Informationen, die sukzessive nacheinander abzuholen sind. Durch die Erfindung können die Abfragevorgänge nach Maßgabe des jeweiligen Andranges von in jedem der Zwischenspeicher abrufbereiten und dem Prozessor P zur Verarbeitung zuzuführenden Informationen auf diese Zwischenspeicher fallweise und bedarfsgemäß verschieden konzentriert werden.

## Patentansprüche

1. Schaltungsanordnung für Fernmeldeanlagen, insbesondere Fernsprechvermittlungsanlagen, mit eine Vielzahl von Abfragestellen (A1–An) zyklisch ansteuernden Informationsabfrageeinrichtungen, die die Abfragestellen zum Abruf gegebenenfalls vorliegender Informationen mit hinsichtlich der verschiedenen Abfragestellen unterschiedlichen Abfragefrequenzen ansteuern und die Abfragefrequenz jeweils bezüglich einer Abfragestelle in Abhängigkeit vom Auftreten einer abzurufenden Information ändern, und mit den Informationsabfrageeinrichtungen zugeordneten Abfragespeichern, in denen für jede der Abfragestellen einzeln die individuelle Anzahl von Ansteuerungsvorgängen innerhalb eines jeweils sämtliche Abfragestellen erfassenden Gesamtansteuerungszyklusses gespeichert ist, wobei in dem Abfragespeicher für jede der Abfragestellen die individuelle Anzahl von Ansteuerungsvorgängen mittels entsprechend ein- oder mehrmaliger Speicherung ihrer jeweiligen Adresse an einer dementsprechenden Zahl von Speicherstellen gespeichert ist, die innerhalb der zyklischen Folge der Gesamtheit der Speicherstellen verteilt, insbesondere regelmäßig verteilt sind und sukzessive zyklisch nacheinander gelesen werden, **dadurch gekennzeichnet**, daß nach einem Lesen einer Adresse einer Abfragestelle (y1–yn) aus einer zuerst erreichten Speicherstelle bei Ausbleiben einer nach Ansteuerung dieser Abfragestelle mit dieser Adresse von dieser Abfragestelle jeweils erwarteten Information in dem Speicher anhand der betreffenden Adresse diejenige nächste weitere Speicherstelle aufgesucht wird, an der die gleiche Adresse gespeichert ist, daß hier in Zuordnung zu dieser Adresse ein Merkbit gespeichert wird (x1, xn), daß danach die auf die zuerst erreichte Speicherstelle unmittelbar folgende Speicherstelle zur Fortsetzung des sukzessive aufeinander folgenden Lesens der gespeicherten Adressen aufgesucht wird, daß bei Vorliegen eines an einer Speicherstelle gespeicherten Merkbits eine Ansteuerung der betreffenden, mittels dieser Adresse ansteuerbaren Abfragestelle unterdrückt wird, und daß hierbei das Merkbit wieder gelöscht wird.

2. Schaltungsanordnung nach Anspruch 1, **dadurch gekennzeichnet**, daß eine Abfragespeicher-Ansteuereinrichtung (E) nach erfolgter Speicherung des Merkbits zu einem gegenüber einem Vorwärts-Suchlauf von der zuerst erreichten Speicherstelle zu der nächsten Speicherstelle, in der die Speicheradresse gespeichert ist, entgegengesetzt gerichteten Rückwärts-Suchlauf umgesteuert wird, bei dem erneut die gleiche gespeicherte Adresse gesucht wird, und daß die Abfragesteuer-Ansteuereinrichtung (E) nach erneutem Erreichen der zuerst erreichten Speicherstelle abermals umgesteuert und wieder in Vorwärtsrichtung um eine Speicherstelle weitergeschaltet wird.

3. Schaltungsanordnung nach Anspruch 1, **dadurch gekennzeichnet**, daß eine Abfrage-Ansteuereinrichtung bei einem Vorwärts-Suchlauf von der zuerst erreichten Speicherstelle zu der nächsten Speicherstelle, in der die gleiche Adresse gespeichert ist, die Anzahl der dabei abgesuchten Speicherstellen zählt und speichert, und daß die Abfragespeicher-Ansteuereinrichtung anschliessend an den erfolgten Vorwärts-Suchlauf entgegengesetzt zu diesem um eine Anzahl von Speicherstellen wieder rückwärts geschaltet wird, die um eins kleiner ist als die beim Vorwärts-Suchlauf zurückgelegte und gespeicherte Anzahl von dabei gezählten Speicherstellen, und daß bei der so erreichten Speicherstelle das zyklische Lesen der Adressen von Abfragestellen fortgesetzt wird.

4. Schaltungsanordnung nach Anspruch 1, **dadurch gekennzeichnet**, daß eine Abfragespeicher-Ansteuereinrichtung bei einem Vorwärts-Suchlauf von der zuerst erreichten Speicherstelle zu der nächsten Speicherstelle, in der die gleiche Adresse gespeichert ist, die Anzahl der dabei abgesuchten Speicherstellen zählt und speichert, daß eine Differenz zwischen dieser Anzahl und der Anzahl vom im Ansteuerzyklus insgesamt enthaltenen Speicherstellen gebildet wird, daß die Abfragespeicher-Ansteuereinrichtung nach erfolgtem Vorwärts-Suchlauf in der gleichen Richtung um eine dieser Differenz entsprechende, jedoch um eins erhöhte Anzahl von Speicherstellen weiter vorwärtsgeschaltet wird, und daß die Abfragespeicher-Ansteuereinrichtung bei der so erreichten Speicherstelle das zyklische Lesen der Adressen von Abfragestellen fortsetzt.

## Claims

1. Circuit arrangement for telecommunication exchanges, particularly telephone exchanges, comprising information interrogation devices which cyclically select a plurality of scanning points (A1–An) and which select the scanning points with scanning frequencies which are different with respect to the various scanning points for calling up any information which may be present and change the scanning frequency in each case with respect to a scanning point in dependence on the occurrence of an information item to be called up, and comprising scanning memories which are allocated to the information interrogation devices and in which the individual number of selection processes within a total selection cycle, in each case covering all scanning points, is stored individually for each of the scanning points, in which arrangement the individual number of selection processes is stored in the scanning memory for each of the scanning points by means of correspondingly single or multiple storage of its respective address at a corresponding number of storage locations which are distributed, particularly regularly distributed, within the cyclic sequence of the totality of storage locations and are progressively cyclically read one after the other, characterized in that, after an address of a scanning point (y1–yn) has been read from a storage location first reached, if an information item in each case expected from this scanning point fails to appear after this scanning point having this address has been selected, the next further storage location at which the same address is stored is located by means of the relevant address in the store, in that a marker bit is here stored in allocation to this address (x1, xn), in that thereafter the storage location immediately following the storage location first reached is located for continuing the progressively successive reading of the stored addresses, in that, when a marker bit stored at a storage location is present, a selection of the relevant scanning point which can be selected by means of this address is suppressed and in that during this process the marker bit is deleted again.

2. Circuit arrangement according to Claim 1, characterized in that, after the marker bit has been stored, a scanning memory selection device (E) is reversed into a reverse search run which is oppositely directed compared with a forward search run from the storage location first reached to the next storage location in which the memory address is stored, in which reverse search run the same stored address is again searched for, and in that the scanning memory selection device (E), after again having reached the storage location first reached, is again reversed and is again stepped on by one storage location in the forward direction.

3. Circuit arrangement according to Claim 1, characterized in that a scanning selection device counts and stores the number of storage locations searched for during a forward search run from the storage location first reached to the next storage location in which the same address is stored, and in that the scanning memory selection device, subsequent to the forward search run effected, is stepped back again in opposition to this search run by a number of storage locations which is less by one than the number of storage locations stepped and stored during the forward search run, and in that the cyclic reading of the addresses of scanning points is continued at the storage location thus reached.

4. Circuit arrangement according to Claim 1, characterized in that a scanning memory selection device counts and stores the number of storage locations searched for during a forward search run from the storage location first reached to the next storage location in which the same address is stored, in that a difference between this number and the number of storage locations contained overall in the selection cycle is formed, in that, an effected forward search run subsequent to the scanning memory device is stepped further forward in the same direction by a number of storage locations corresponding to this difference but increased by one, and in that the scanning memory selection device continues the cyclic reading of the addresses of scanning points at the storage location thus reached.

## Revendications

1. Montage pour des installations de télécommunications, notamment des centraux téléphoniques, comportant des dispositifs d'interrogation d'informations, qui commandent une multiplicité de postes d'interrogation (A1–An), commandent ces postes d'interrogation pour l'appel d'informations éventuellement présentes, avec des fréquences d'interrogation qui diffèrent entre les différents postes d'interrogation, et modifient la fréquence d'interrogation respectivement en rapport avec un poste d'interrogation, en fonction de l'apparition d'une information devant être appelée, et des mémoires d'interrogations, qui sont associées aux dispositifs d'interrogation d'informations et dans lesquelles le nombre individuel de processus de commande à l'intérieur d'un cycle global de commande, qui inclut respectivement tous les postes d'interrogation, est mémorisée individuellement pour chacun des postes d'interrogation, auquel cas dans la mémoire d'interrogations et pour chacun des postes d'interrogation, le nombre individuel de processus de commande est mémorisé au moyen d'une mémorisation unique ou répétée correspondante de l'adresse respective des postes d'interrogation, dans un nombre correspondant d'emplacements de mémoire, qui sont répartis à l'intérieur de la séquence cyclique de la totalité des postes de mémoire, et ce notamment d'une manière régulière, et sont lus successivement de façon cyclique, caractérisé par le fait qu'après la lecture d'une adresse d'un poste d'interrogation (y1–yn) à partir d'un emplacement de mémoire atteint en premier, lors de l'absence d'une information respectivement attendue par un poste d'interrogation après la commande de ce poste par cette adresse, une recherche est exécutée dans la mémoire, sur la base de l'adresse concernée, pour trouver l'emplacement de mémoire immédiatement suivant, auquel cette même adresse est mémorisée, qu'un bit de marquage (x1, xn) est mémorisé dans cet emplacement de mémoire, en association à cette adresse, qu'ensuite l'emplacement de mémoire, qui succède directement à l'emplacement de mémoire atteint en premier est recherché en vue de la poursuite de la lecture successive des adresses mémorisées, que lors de la présence d'un bit de marquage mémorisé en un emplacement d'adresse, une commande du poste considéré d'interrogation, pouvant être commandé au moyen de cette adresse, est supprimé et qu'alors le bit de marquage est à nouveau effacé.

2. Montage suivant la revendication 1, caractérisé par le fait qu'après la mémorisation du bit de marquage, le dispositif (E) de commande de la mémoire d'interrogations est commuté sur un cycle de recherche rétrograde, qui est dirigé en sens opposé d'un cycle de recherche directe depuis l'emplacement de mémoire atteint en premier en direction de l'emplacement de mémoire immédiatement suivant, lors duquel l'adresse de mémoire est mémorisée et lors duquel la même adresse mémorisée est à nouveau recherchée, et que la commande du dispositif (E) de commande de la mémoire d'interrogation est à nouveau inversée lorsqu'est à nouveau atteint l'emplacement de mémoire atteint en premier lieu, et que ce dispositif est à nouveau avancé d'un emplacement de mémoire dans le sens direct.

3. Montage suivant la revendication 1, caractérisé par le fait que lors d'un cycle de recherche direct de l'emplacement de mémoire atteint en premier jusqu'à l'emplacement de mémoire immédiatement suivant, dans lequel la même adresse est mémorisée, un dispositif de commande de la mémoire d'interrogations compte et mémorise le nombre des emplacements de mémoire explorés lors de la recherche et qu'à la suite du cycle de recherche direct, le dispositif de commande de la mémoire d'interrogations est à nouveau rétrogradé, en sens opposé de ce cycle, d'un nombre d'emplacements de mémoire inférieur d'une unité au nombre d'emplacements de mémoire comptés, parcourus et mémorisés lors du cycle de recherche directe, et qu'au niveau de l'emplacement de mémoire ainsi atteint, la lecture cyclique des adresses de postes d'interrogation se poursuit.

4. Montage suivant la revendication 1, caractérisé par le fait que lors d'un cycle de recherche avant de l'emplacement de mémoire atteint en premier jusqu'à l'emplacement de mémoire immédiatement suivant, dans lequel la même adresse est mémorisée, un dispositif de commande de la mémoire d'interrogations compte et mémorise le nombre des emplacements de mémoire explorés lors de la recherche, qu'une différence entre ce nombre et le nombre d'emplacements de mémoire parcourus globalement lors du cycle de commande est formée, qu'après le cycle de recherche direct, le dispositif de commande de la mémoire d'interrogations est à nouveau avancé dans le même sens, d'un nombre d'emplacements de mémoire, qui correspond à cette différence, mais est accru d'une unité, et qu'au niveau de l'emplacement de mémoire ainsi atteint, le dispositif de commande de la mémoire d'interrogations poursuit la lecture cyclique des adresses de postes d'interrogation.